**Europäisches Patentamt**

**European Patent Office**

**Office européen des brevets**

(19)

(11) Veröffentlichungsnummer: **0 025 195**
**B1**

(12) **EUROPÄISCHE PATENTSCHRIFT**

(45) Veröffentlichungstag der Patentschrift: **03.12.86**

(51) Int. Cl.⁴: **H 05 K 9/00**

(21) Anmeldenummer: **80105139.2**

(22) Anmeldetag: **28.08.80**

(54) Geschirmte Baugruppe.

(30) Priorität: **11.09.79 DE 2936715**

(43) Veröffentlichungstag der Anmeldung:
**18.03.81 Patentblatt 81/11**

(45) Bekanntmachung des Hinweises auf die
Patenterteilung:
**03.12.86 Patentblatt 86/49**

(84) Benannte Vertragsstaaten:
**AT BE CH FR IT LI LU NL SE**

(56) Entgegenhaltungen:
**DD-A- 131 516**
**DE-A-1 441 114**
**DE-A-2 323 445**
**GB-A-1 462 058**
**GB-A-2 029 645**
**US-A-3 895 267**

(73) Patentinhaber: **Siemens Aktiengesellschaft
Berlin und München
Wittelsbacherplatz 2
D-8000 München 2 (DE)**

(72) Erfinder: **Wandiger, Franz, Ing.grad.
Hochnisslstrasse 3
D-8000 München 82 (DE)**
Erfinder: **Kerscher, Franz, Ing.grad.
Böcklerweg 13
D-8000 München 82 (DE)**
Erfinder: **Voigt, Ulrich, Dipl.-Ing.
Unertlstrasse 31
D-8000 München 40 (DE)**

Anmerkung: Innerhalb von neun Monaten nach der Bekanntmachung des Hinweises auf die Erteilung des europäischen Patents im Europäischen Patentblatt kann jedermann beim Europäischen Patentamt gegen das erteilte europäische Patent Einspruch einlegen. Der Einspruch ist schriftlich einzureichen und zu begründen. Er gilt erst als eingelegt, wenn die Einspruchsgebühr entrichtet worden ist (Art. 99(1) Europäisches Patentübereinkommen).

EP 0 025 195 B1

## Beschreibung

Die Erfindung betrifft eine geschirmte Baugruppe, insbesondere Filterbaugruppe zum Anschluß von ungeschirmten Leitungen an Datenübertragungsanlagen mit einer elektrische Bauelemente sowie Ein- und Ausgangssteckverbinder tragenden gedruckten Leiterplatte, die von einem aus Gehäuseunterteil und Deckel bestehenden Metallgehäuse allseitig umschlossen ist.

Der Anschluß von ungeschirmten Leitungen an einem Datenübertragungsprozessor muß über ein Entstörmittel erfolgen, das bestimmte vorgegebene Störgrenzwerte erfüllt. Ein derartiges Entstörmittel besteht dabei im wesentlichen aus zwei Filtermoduln, die auf einer Leiterplatte gelötet und in ein Gehäuse eingebaut sind.

In der US-Patentschrift 3 895 267 ist ein Modulgehäuse für eine elektrische Schaltung beschrieben, das zur Aufnahme einer steckbaren Leiterplatte mit gedruckter Schaltung dient, wobei das Gehäuse aus leitfähigem Material besteht, so daß es als Schirm für die beinhaltete Baugruppe wirkt.

Aufgabe der vorliegenden Erfindung ist es, ein Gehäuse für Bauelemente insbesondere für Entstörmittel in Datenübertragungsanlagen zu schaffen, das bei geringem Platzbedarf eine gute HF-mäßige Abschirmung bewirkt.

Zu Lösung dieser Aufgabe wird gemäß der Erfindung die geschirmte Baugruppe derart ausgebildet, daß das Gehäuseunterteil, das aus einer rechteckigen Grundplatte mit auf zwei Längsseiten und einer Schmalseite senkrecht auf dieser Grundplatte stehenden Seitenwänden besteht und das in der Ebene der offenen Schmalseitenwand mit zwei nach außen gebogenen, senkrecht auf den Längsseitenwänden und der Grundplatte stehenden Lappen versehen ist, wobei in der anderen Schmalseitenwand sich ein fensterartiger Durchbruch befindet, hinter dem ein mit einer metallischen Schirmung versehener Eingangssteckverbinder eng mit dem Gehäuseunterteil verbunden ist, daß die Seitenwände des Gehäuseunterteils mit einer mechanischen Vorspannung versehen sind, so daß sie sich fest an den aufschiebbaren rechteckigen Deckel legen, der einen aufgekanteten, umlaufenden Rand hat und dessen Rand auf einer Schmalseite so erweitert ist, daß er die offenen Schamlseitenwand des Gehäuseunterteils und die Lappen vollständig abdeckt, daß dieser Schmalseitenrand des Deckels einen Durchbruch enthält, durch den der Ausgangssteckverbinder und die über die Kontakt des Ausgangssteckverbinders hinausragende gedruckte Leiterplatte hindurchgeführt sind, daß eine Massefläche der Leiterplatte mit dem Gehäuseunterteil über Abstandsrohre durch eine lösbare mechanische Verbindung gut elektrisch leitend kontaktiert ist und daß Gehäuseunterteil und Deckel ebenfalls mittels einer lösbaren mechanischen Verbindung zusammengepreßt sind, so daß ein elektrisch gut leitender Kontakt entsteht.

Durch diese Maßnahmen erhält man ein einfach aufgebautes HF-dichtes Gehäuse, das mit wenigen Handgriffen zusammengebaut und am jeweiligen Einsatzprojekt leicht untergebracht werden kann. Dabei wird außerdem erreicht, daß der Filterraum vom ebenfalls geschirmten Geräteraum, wie z.B. dem Datenübertragungsprozessor, getrennt ist und Störungen über das Filtergehäuse bereits außerhalb des Geräteraumes abgeleitet werden können.

Am Gehäuseunterteil können in der Nähe der vier Ecken Schraubbolzen angebracht sein, die durch die Abstandsrohre und die gedruckten Leiterplatten hindurchragen, wobei auf die Schraubbolzen Muttern aufgebracht werden, die die Leiterplatte und das Gehäuseunterteil fest miteinander verbinden.

Dadurch wird eine gute HF-mäßige Verbindung zwischen dem Massebelag der gedruckten Leiterplatte und dem Gehäuse erreicht.

Mindestens zwei Muttern, insbesondere die vorderen Muttern, können so ausgebildet sein, daß die über die Schraubbolzen hinausragen, so daß weitere Schrauben vom Boden durch den Deckel in diese Muttern einführbar sind.

Dadurch wird eine einfache Befestigung des Deckels mit dem Gehäuseunterteil und gleichzeitig eine gute HF-Dichtigkeit erzielt.

Eine andere Möglichkeit, Deckel und Gehäuseunterteil ohne Schraubverbindung miteinander zu verbinden, besteht darin, daß die Wangen des Deckels und die Enden der Gehäuseunterteilseitenwände schwalbenschwanzähnlich ausgeformt sind.

Es ist auch möglich, die vorderen Schraubbolzen und Abstandsrohre gänzlich wegzulassen und die Kontaktierung zwischen der Massefläche der Leiterplatte und dem Gehäuseunterteil an der Seite des Eingangssteckverbinders durch eine Feder vorzunehmen. Dabei kann entweder eine U-förmig gebogene Blattfeder oder eine Wellfeder verwendet werden.

Eine zusätzliche Verbesserung der Schirmung erhält man, wenn man die Massefläche der Leiterplatte und das Gehäuseunterteil durch eine Lötverbindung zusätzlich kontaktiert.

Anhand der Ausführungsbeispiele nach den Figuren 1 bis 4 wird die Erfindung näher erläutert.

Fig. 1 zeigt dabei einen Längsschnitt durch die geschirmte Baugruppe,
Fig. 2 eine Draufsicht,
Fig. 3 ein Rückansicht und
Fig. 4 ein Detail bei einer Baugruppe, bei der Deckel und Unterteil des Gehäuses schwalbenschwanzförmig ausgebildet sind.

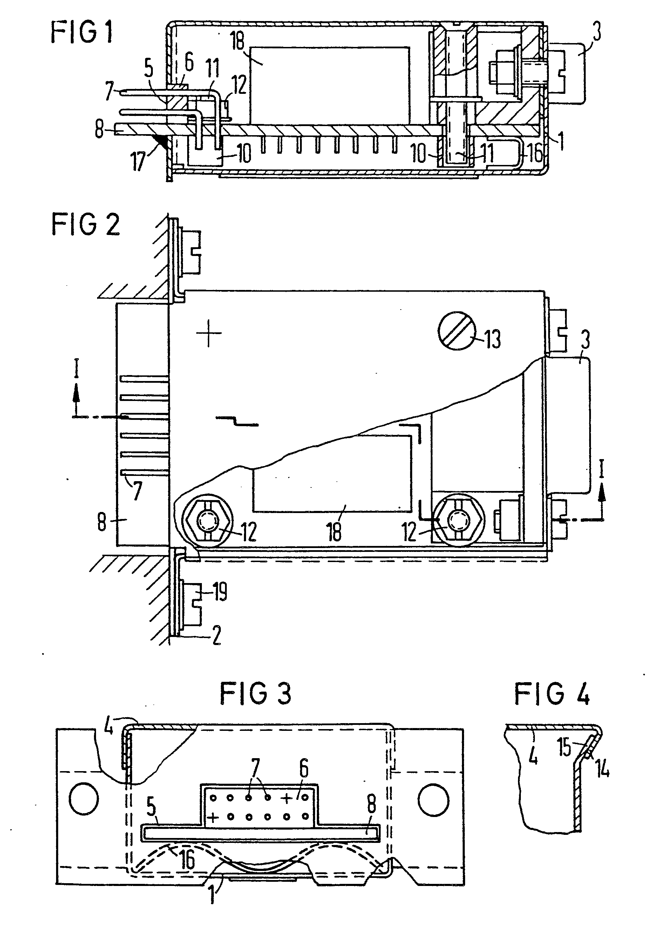

Wie in Fig. 1 dargestellt, besteht die geschirmte Baugruppe aus einem Gehäuseunterteil 1 und dem dazugehörigen Deckel 4. Das Gehäuseunterteil ist dabei so ausgebildet, daß es nach hinten und nach oben offen ist und außerdem an seiner Vorderseite einen Durchbruch enthält. An der Rückseite sind zwei Lappen 2 nach außen gebogen. Sie dienen für die spätere Befestigung der gesamten geschirmten Baugruppe an der Geräteeinheit. Die Lappen sind mit Bohrungen versehen, durch die Schrauben 19 hindurchführbar sind.

Die Baugruppe enthält ferner eine gedruckte Leiterplatte 8, auf der die Entstörmittel im vorliegenden Falle zwei Filtermodule aufgebracht sind. Eingangsseitig ist auf dieser Leiterplatte ein Eingangssteckverbinder 3 und ausgangsseitig ein Ausgangssteckverbinder 6 angebracht. Der Eingangssteckverbinder 3 ist an seiner Vorderseite mit einer metallischen Platte belegt, die in ein Hohlrohr einmündet, das die Schirmung der Steckkontakte dieses Stecker bewirkt. In der vorliegenden Ausführung ist dabei ein sogenannter Trapezstecker verwendet. Es kann jedoch auch ein beliebig anderer Stecker hierfür eingesetzt werden. Die metallische Fläche des Eingangssteckverbinders 3 ist hinter der Vorderseite des Gehäuseunterteils mit dieser fest verschraubt, so daß die hohlrohrförmige Schirmausbildung durch den Durchbruch, der sich an der Vorderseite des Gehäuseunterteils befindet, hindurchragt. Zwischen der Leiterplatte 8 und dem Gehäuseunterteil sind bei einer Ausführungsform in der Nähe der vier Ecken metallische Abstandsrohre angebracht, durch die am Boden des Gehäuseunterteils befestigte Schraubbolzen 11 hindurchragen. Die Leiterplatte 8 und das Gehäuseunterteil werden über Muttern 12 gegenseitig miteinander verschraubt, so daß sich ein guter Massekontakt ergibt. Die vorderen Muttern 12 sind dabei so ausgebildet, daß sie in ihrer Höhe über den jeweiligen Gewindebolzen 11 hinausragen, so daß von oben her weiter Schrauben 13 in diese Muttern einführbar sind, wodurch gleichzeitig auch der Deckel mit dem Gehäuseunterteil fest verbunden ist.

Anstelle der vorderen Abstandsrohre läßt sich auch eine Feder 16 anbringen, die im Beispiel nach Fig. 1 als Blattfeder ausgebildet ist. Diese Feder kontaktiert die Massefläche 9 der Leiterplatte 8 mit dem Gehäuseunterteil. Diese Ausführung ist allerdings nur dann anwendbar, wenn gleichzeitig anstelle der Schraubverbindung zwischen Deckel und Gehäuse die später noch erläuterte schwalbenschwanzförmige Ausbildung des Deckels und der Gehäuseunterteilseiten tritt. Die Leiterplatte 8 ist an ihrem hinteren Ende durch einen Durchbruch 5 im Deckel geführt und überragt damit die Kontakt 7 des Ausgangssteckverbinders 6, wodurch eine gute Schirmung auch dieser Steckkontakt und ein symmetrischer Aufbau der Ableitungsfläche erreicht wird, so daß das Einkoppeln von Störungen verhindert wird.

In der Draufsicht nach Fig. 2 erkennt man die Befestigung der geschirmten Baugruppe mit dem Datenübertragungsprozessor über die Schraubverbindung 19. Der Deckel 4 ist nur teilweise gezeichnet, so daß man auch das Innere der Baugruppe 10 sehen kann. Dabei sieht man eine der beiden Filterbaugruppen 18 sowie die unterschiedliche Ausbildung der vorderen und hinteren Muttern 12. Während es sich bei den hinteren Muttern um Muttern mit normaler Bauhöhe handelt, sind die vorderen Muttern verlängert und mit einem Querschlitz zum Einschrauben versehen. Die Anschlüsse des neunpoligen Eingangssteckverbinders 3, der als Trapezsteckverbinder ausgebildet ist, liegen unter der an der Vorderseite sichtbaren Abschirmung. Der Eingangssteckverbinder 3 ist, wie bereits oben erläutert, mit der Frontseite des Gehäuseunterteiles verschraubt. Dabei kontaktiert die metallische Fläche des Eingangssteckverbinders 3 die Frontseite des Gehäuseunterteils 1, wodurch ein guter Kontakt für die Schirmung hergestellt wird.

Wie aus Fig. 3 ersichtlich, ist der Deckel U-förmig gebogen und an seiner Rückseite so erweitert, daß er sowohl die Rückseite des Gehäuseunterteils als auch die angewinkelten Lappen 2 abdeckt. Anstalle einer Blattfeder ist in Fig. 3 ein Wellfeder zur Kontaktierung der Massefläche 9 der Leiterplatte und des Gehäuseunterteiles verwendet. Da diese Feder an der Vorderseite sitzt, ist sie strichliert eingezeichnet.

Fig. 4 zeigt eine Ausführungsform, bei der die Deckelwannen und die oberen Enden der Seitenteil des Gehäuseunterteiles schwalbenschwanzförmig abgewinkelt sind. Dadurch erübrigt sich eine Schraubverbindung des Deckels mit dem Gehäuseunterteil, da Deckel und Gehäuseunterteil fest aufeinander haften. Die Deckelseiten sind dabei mit 14 und die abgebogenen Enden der Seitenteil des Gehäuseunterteils mit 15 bezeichnet.

Deckel und Gehäuseunterteil sind bei den bisher beschriebenen Ausführungsformen als Blechteile ausgebildet. Sie können jedoch auch aus zwei Druckgußschalen bestehen; die über Schnappelements zusammengehalten werden. Dabei kann die Halterung und Kontaktierung der Leiterplatte und der Stecker durch geeignete Ausformung der Druckgußschalen erfolgen.

**Patentansprüche**

1. Abgeschirmte Baugruppe, insbesondere Filterbaugruppe zum Anschluß von ungeschirmten Leitungen an Datenübertragungsanlagen, mit einer elektrische Bauelemente sowie Ein- und Ausgangssteckverbinder tragenden gedruckten Leiterplatte, die von einem aus Gehäuseunterteil und Deckel bestehenden Metallgehäuse allseitig umschlossen ist, dadurch gekennzeichnet, daß das Gehäuseunterteil (1), das aus einer rechteckigen Grundplatten mit auf zwei Längsseiten und einer Schmalseite senkrecht auf dieser Grundplatte stehenden Seitenwänden besteht und das in der Ebene der offenen Schmalseitenwand mit zwei nach außen gebogenen, senkrecht auf den Längsseitenwand und der Grundplatte stehenden Lappen (2) versehen ist, wobei in der anderen Schmalseitenwand sich ein fensterartiger Durchbruch befindet, hinter dem ein mit einer metallischen Schirmung versehener Eingangssteckverbinder (3) eng mit dem Gehäuseunterteil (1) verbunden ist, daß die Seitenwände des Gehäuseunterteils (1) mit einer mechanischen Vorspannung versehen sind, so daß sie sich fest an den aufschiebbaren rechteckigen Deckel (4) legen, der einen aufgekanteten, umlaufenden Rand hat un dessen Rand auf einer Schmalseite so erweitert ist, daß er die offene Schmalseitenwand des Gehäuseunterteils (1) und die Lappen (2) vollständig abdeckt, daß dieser Schamalseitenrand des Deckels einen Durchbruch (5) enthält, durch den der Ausgangssteckverbinder (6) und die über die Kontakte (7) des Ausgangssteckverbinders (6) hinausragende gedruckte Leiterplatte (8) hindurchgeführt sind, daß eine Massefläche der Leiterplatte (8) mit dem Gehäuseunterteil (1) über Abstandsrohre (10) durch eine lösbare mechanische Verbindung gut elektrisch leitend kontaktiert ist und daß Gehäuseunterteil (1) und Deckel (4) ebenfalls mittels einer lösbaren mechanischen Verbindung zusammengepreßt sind, so daß ein elektrisch gut leitender Kontakt entsteht.

2. Geschirmte Baugruppe nach Anspruch 1, dadurch gekennzeichnet, daß am Gehäuseunterteil (1) in der Nähe der vier Ecken Schraubbolzen (11) angebracht sind, die durch die Abstandsrohre (10) und die gedruckte Leiterplatte (8) hindurchragen und daß auf diesen Schraubbolzen Muttern zum Zwecke der Befestigung der Leiterplatte (8) mit dem Gehäuseunterteil angebracht sind.

3. Geschirmte Baugruppe nach Anspruch 2, dadurch gekennzeichnet, daß mindestens zwei Muttern (12), insbesondere die vorderen Muttern über die Schraubbolzen (11) hinausragen, so daß weitere Schrauben (13) von oben durch den Deckel (4) einführbar sind.

4. Geschirmte Baugruppe nach einem der Ansprüche 1 oder 2, dadurch gekennzeichnet, daß die Wangen (14) des Deckels (4) und die Enden (15) der Gehäuseunterteilseitenwände schwalbenschwanzähnlich ausgeformt sind.

5. Geschirmte Baugruppe nach einem der Ansprüche 1 bis 4, dadurch gekenzeichnet, daß die Kontaktierung zwischen der Massenfläche (9) der Leiterplatte (8) und dem Gehäuseunterteil (1) an der Seite des Eingangssteckverbinders (3) durch eine Feder (16) erfolgt.

6. Geschirmte Baugruppe nach Anspruch 5, dadurch gekennzeichnet, daß die Feder (16) eine U-förmig gebogene Blattfeder ist.

7. Geschirmte Baugruppe nach Anspruch 5, dadurch gekennzeichnet, daß die Feder (16) eine Wellfeder ist.

8. Gaschirmte Baugruppe nach einem der vorhergehenden Ansprüche, dadurch gekennzeichnet, daß die Massefläche (9) der Leiterplatte (8) und das Gehäuseunterteil (1) durch eine Lötverbindung (17) zusätzlich kontaktiert sind.

**Revendications**

1. Assemblage de circuits blindé, en particulier assemblage de circuits de filter pour le raccordement de conducteurs non blindés à des installations pour la transmission de données, avec un plaquette de circuits imprimés pourvue de composants électriques ainsi que de connecteurs d'entrée et de sortie et entourée de toutes part d'un boîtier métallique constitué par un élément de boîtier inférieur et un couvercle, caractérisé par le fait que l'élément de boîtier inférieur (1), qui est constitué par une plaque de base rectangulaire avec des parois latérales perpendiculaires sur cette dernière au niveau de deux côtés longitudinaux et d'un côté étroit et qui, dans le plan du côté latéral étroit et ouvert, est pourvue de deux pattes (2) reliées vers l'extérieur et s'étendant perpendiculairement aux parois latérales longitudinales et à la plaque de base, l'autre paroi latérale étroite étant pourvue d'une ouverture derrière laquelle un connecteur d'entrée (3), pourvu d'un blindage métallique, est relié étroitement avec l'élément de boîtier inférieur (1), que les parois latérales de l'élément de boîtier inférieur (1) sont pourvues d'une précontrainte mécanique de manière à s'appliquer fermement contre le couvercle coulissant et rectangulaire (4) qui possède un bord périphérique replié vers le haut et dont le bord est élargi sur un côté étroit de manière à recouvrir complètement la paroi latérale étroite ouverte de l'élément de boîtier inférieur (1) ainsi que les pattes (2), que ce bord du côté étroit du couvercle présente une ouverture (5) qui est traversée par le connecteur de sortie (6) et par la plaquette à circuits imprimés (8) qui déborde les contacts (7) du connecteur de sortie (6), qu'une surface de masse de la plaquette à circuits imprimés (8) est reliée avec bon contact électrique à l'élément de boîtier inférieur (1), par des tubes d'entretoises (11) et à l'aide d'une liaison mécanique détachable, et que l'élément de boîtier inférieur (1) et le couvercle (4) sont appliqués fermement l'un contre l'autre, également à l'aide d'une liaison mécanique détachable, de manière qu'il se forme un contact électrique bon conducteur.

2. Assemblage de circuits blindé selon la revendication 1, caractérisé par le fait que sur l'élément de boîtier inférieur (1) sont montés, dans le voisinage des quatre sommets, des boulons (11) qui passent par les tubes d'entretoises (10) et par la plaque à circuits imprimés (8), et que sur ces boulons sont montés des écrous dans le but de solidariser la plaquette à circuits imprimés (8) avec l'élément de boîtier inférieur.

3. Assemblage de circuits blindé selon la revendication 2, caractérisé par le fait qu'au moins deux écrous (12), en particulier les écrous antérieurs, débordent les boulons (11), en sorte que d'autres boulons (13) peuvent être introduits, par le haut, à travers le couvercle (4).

4. Assemblage de circuits blindé selon l'une des revendications 1 ou 2, caractérisé par le fait que les joues (14) du couvercle (4) et les extrémités (15) des parois latérales et inférieures du boîtier sont conformées en queue d'aronde.

5. Assemblage de circuits blindé selon l'une des revendications 1 à 4, caractérisé par le fait que l'établissement du contact entre la surface de masse (9) de la plaquette à circuits imprimés (8) et l'élément de boîtier inférieur (1), a lieu sur le côté du connecteur d'entrée (3) à l'aide d'un ressort (16).

6. Assemblage de circuits blindé selon la revendication 5, caractérisé par le fait que le ressort (16) est une lame de ressort repliée en forme de U.

7. Assemblage de circuits blindé selon la revendication 5, caractérisé par le fait que le ressort (16) est un ressort ondulé.

8. Assemblage de circuits blindé selon l'une des revendications précédentes, caractérisé par le fait que la surface de masse (9) de la plaquette à circuits imprimés (8) et l'élément de boîtier inférieur (1) sont contactés, en plus, par une liaison à soudure (17).

## Claims

1. A screened assembly, in particular a filter assembly for the connection of unscreened lines to data transmission appliances, comprising a printed circuit board which supports electric components and input and output plug connectors, and is enclosed by a metal housing consisting of a base and a cover, characterised in that the base (1) consists of a rectangular base plate with lateral walls at right angles to said base plate on two longitudinal sides and one narrow side and provided in the plane of the open wall of the narrow side with two outwardly bent lugs (2) vertically positioned on the walls of the longitudinal sides and the base plate, a window-like opening in the other wall of the narrow side, behind which an input plug connector (3) provided with a metallic screen is closely connected to the base (1), that the lateral walls of the base (1) are provided with a mechanical bias, so that they firmly rest against the slidable rectangular cover (4), which possesses a peripheral canted border widened on one narrow side in such a manner that it completely covers the open wall of the narrow side of the base (1) and the lugs (2), that said border of the narrow side of the cover comprises an opening (5) through which are passed the output plug connector (6) and the printed circuit board (8), which protrudes beyond the contacts (7) of the output plug connector (6), that an earth surface of the circuit board (8) is in contact with the base (1) via spacer sleeves (10) by a releasable mechanical connection, so as to be highly electrically conductive, and that the base (1) and cover (4) are pressed together by a releasable mechanical connection to form a highly electrically conductive contact.

2. A screened assembly as claimed in Claim 1, characterised in that screw bolts (11), protruding through the spacer sleeves (10) and the printed circuit board (8), are fixed on the base (1) in the vicinity of the four corners, and that nuts for securing the circuit board (8) to the base are positioned on said screw bolts.

3. A screened assembly as claimed in Claim 2, characterised in that at least two nuts (12), in particular the front nuts, project over the screw bolts (11) so that further screws (13) can be inserted from the top through the cover (4).

4. A screened assembly as claimed in one of Claims 1 or 2, characterised in that the side plates (14) of the cover (4) and the ends (15) of the lateral walls of the base are dovetailed.

5. A screened assembly as claimed in one of Claims 1 to 4, characterised in that contact between the earth surface (9) of the circuit board (8) and the base (1) is effected by a spring (16) on the side of the input plug connector (3).

6. A screened assembly as claimed in Claim 5, characterised in that the spring (16) is a U-shaped leaf spring.

7. A screened assembly as claimed in Claim 5, characterised in that the spring (16) is a corrugated spring.

8. A screened assembly as claimed in one of the preceding Claims, characterised in that the earth surface (9) of the circuit board (8) and the base (1) are additionally contacted by a solder connection (17).

FIG 1

FIG 2

FIG 3

FIG 4